**Europäisches Patentamt**

**European Patent Office**

**Office européen des brevets**

(19)

(11) Veröffentlichungsnummer: **0 053 303**
**B1**

# EUROPÄISCHE PATENTSCHRIFT

(12)

(45) Veröffentlichungstag der Patentschrift:
19.03.86

(51) Int. Cl.⁴: **H 03 G 7/00**

(21) Anmeldenummer: 81109566.0

(22) Anmeldetag: 07.11.81

(54) Schaltung zur Dynamik-Kompression und/oder -Expansion.

(30) Priorität: 27.11.80 DE 3044661

(43) Veröffentlichungstag der Anmeldung:
09.06.82 Patentblatt 82/23

(45) Bekanntmachung des Hinweises auf die Patenterteilung:
19.03.86 Patentblatt 86/12

(84) Benannte Vertragsstaaten:
AT BE CH DE FR GB IT LI LU NL SE

(56) Entgegenhaltungen:
DE - B - 2 406 258
FR - A - 1 354 777
US - A - 3 789 143
US - A - 4 038 566

THE JOURNAL OF THE ACOUSTICAL SOCIETY OF
JAPAN, Band 32, Nr. 9, September 1976, Seiten 582-587,
Tokyo, JP. K. YAMMOTO: "DBX noise reduction system"

(73) Patentinhaber: ANT Nachrichtentechnik GmbH,
Gerberstrasse 33, D-7150 Backnang (DE)

(72) Erfinder: Wermuth, Jürgen, Ing. grad., Drosselweg 1,
D-3154 Peine-Stederdorf (DE)

(74) Vertreter: Schickle, Gerhard, Dipl.-Ing., ANT
Nachrichtentechnik GmbH Patent- und Lizenzabteilung
Gerberstrasse 33, D-7150 Backnang (DE)

## Beschreibung

Die Erfindung betrifft eine Schaltung nach dem Oberbegriff des Patentanspruchs 1, die beispielsweise durch die DE-PS 24 06 258 bekannt ist. Einen dB-linearen Kennlinienverlauf der Kompresion- bzw-. Expansionkennlinie erhält man, wenn dort verwendeten Stellgliedern im Hauptweg und Zweigweg der Schaltung eine gleiche Steuercharakteristik haben.

Durch die DE-OS 28 42 945 ist es für eine solche Schaltung bekannt, lineare Stellglieder zu verwenden und den Stellgliedern ein Übertragungsglied vorzuschalten, welches eine einer e-Funktion entsprechende Übertragungsfunktion aufweist. Dieses ist für das dynamische Verhalten der Schaltungsanordnung sehr vorteilhaft.

Durch die DE-PS 24 06 258 ist es auch bekannt, daß durch die Zusammenschaltung von mehreren in ihrem Übertragungsmaß veränderbaren Verstärkern zu einer Kettenschaltung unterschiedliche Kompressionsgrade erreicht werden können. Bei Anwendung der in den Figuren 4 und 6 der DE-PS 24 06 258 angegebenen Schaltungen läßt sich beispielsweise ein Kompressionsgrad von 1:1,5 erreichen. Der Aufwand bei diesen Schaltungen ist jedoch erheblich vergrößert, da ein zusätzlicher Verstärker mit einem zusätzlichen Stellglied erforderlich ist.

In der US-A-4,038,566 wird ein Multiplizierer beschrieben, dessen Ausgangssignal in großen Bereichen linear zum Eingangssignal ist. Die Multiplikanten werden logarithmiert, addiert und dann wieder delogarithmiert.

Der Erfindung liegt die aufgabe zugrunde, die beschriebene Kompanderschaltung so zu gestalten, daß beliebige (dB-lineare) Kompressionsgrade auf einfache Weise erhalten werden können, wobei der Aufwand für den Aufbau der Stellglieder gering gehalten werden soll.

Diese Aufgabe wird durch die im Patentanspruch 1 angegebene Erfindung gelöst.

Bei der erfindungsgemäßen Schaltung können beliebige Kompressionsgrade auf einfache Weise dadurch erhalten werden, daß den gesteuerten Stellgliedern im Nutzsignalweg Steuerspannungen mit um einen konstanten Faktor unterschiedlichen Pegeln zugeführt werden. Bei der gewählten Anordnung wirkt sich ein solcher konstanter Faktor liear auf den Kompressionsgrad aus. Die verwendeten Stellglieder mit einer der e-Funktion entsprechenden Steuershakteristik lassen sich im Vergleich zu Stellgliedern mit linearer Charakteristik, die beim Stand der Technik verwendert werden, wesentlich einfacher realisieren. Z.B. kann die bekannte Tatsache ausgenutzt werden, daß sich der Kollektorstrom eines Transistors in Abhängigkeit von der Basis-Spannung nach einer e-Funktion ändert.

Im folgende wird die Erfindung anhand der Zeichnung näher erläutert.

Es zeigen:
Fig. 1 einen Expander mit den erfindungsgemäßen Merkmalen,
Fig. 2 eine bekannte Expansionsschaltung,
Fig. 3 eine zwischen einem Expasions- und einem Kompressionsbetrieb umschaltbare Kompander-Schaltung und
Fig. 4 ein ausfürliches Ausfürungsbeispiel der erfindungsgemäßen Schaltung.

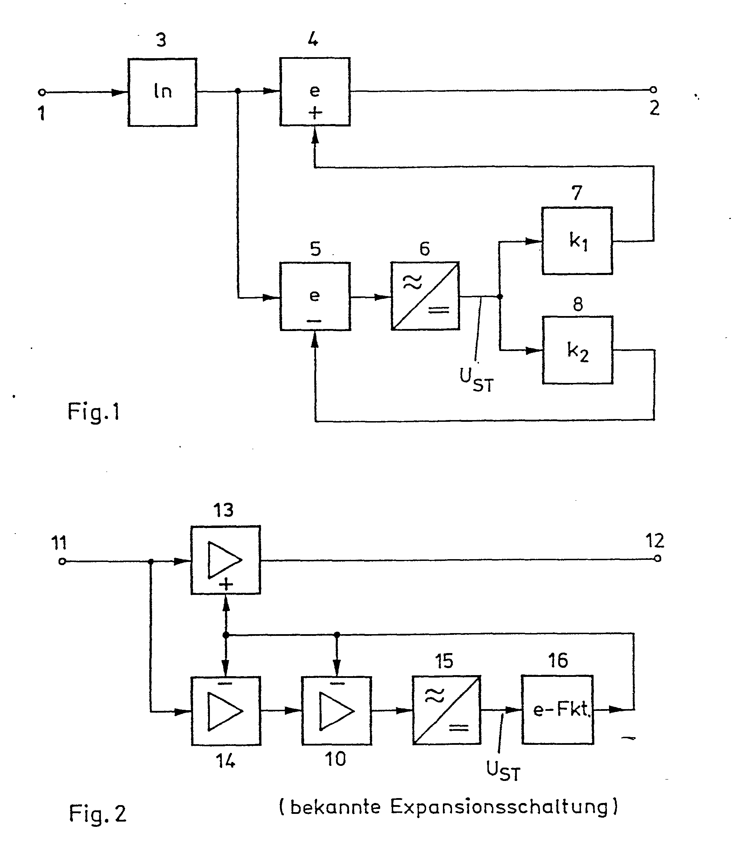

Zunächst wird anhand von Fig. 2 eine bekannte Expansionsschaltung beschrieben. Ein an einer Eingangsklemme 11 zugeführtes Vechselspannungssignal wird über ein in seinem Über-tragungsmaß steuerbares Übertragungsglied 13 zu einer Ausgangsklemme 12 übertragen. Vom Eingang des Übertragungsgliedes 13 wird das gleiche Signal einem Zweigweg mit den Übertragungsgliedern 14 und 10 zugeführt. Vom Ausgang des Üertragungsgliedes 10 wird mittels eines Steuerspannungserzeugers 15 ein Steuersignal abgeleitet. Das Steuersignal $U_{ST}$ wird in einem Schaltungsteil 16 entsprechend einer e-Funktion be-einflußt und linearen Stellgliedern in den Übertragungsgliedern 13,14 und 10 zugeführt. Die in Fig. 2 nicht näher dargestellten Stellglieder sind so angeordnet, daß das Über-tragungsmaß im Hauptweg im positiven Sinn und im Zweigweg im Sinne einer Gegenregelung beeinflußt werden. Der Schaltungsteil 16 kann entfallen, wenn die Stellglieder in den FCbertragungsgliedern 13,14 und 10 selbst eine einer e-Funktion entsprechende Charakteristik haben.

Bei bekannten Kompandersystemen, die aus einem Kompressor und einem Expander aufgebaut sind, muß prinzipiell die Forderung eingehalten werden, daß der Eingangspegel des Expanders genau dem Ausgangspegel des Kompressors entspricht. Pegelverschiebungen können zu Verfälschungen führen. Auf die genannte Forderung kann verzichtet werden, wenn die Kompanderkennlinie "dB-linear",das heißt linear bezüglich des Logarithmus der Eingangsamplitude verläuft. Um diese dB-Linearität zu erhalten, ist der Schatungsteil 16 vorgesehen bzw. wählt man Stellglieder, die eine Charakteristik entsprechend einer e-Funktion aufweisen.

Bei der bekannten Schaltung gemäß Fig. 2 sind drei lineare Stellglieder in den Übertragungsgliedern 13,14 und 10 vorgesehen. Diese sind bei den Kompandern gestellten Genauigkeitsanforderungen nur mit erheblichem Aufwand realisierbar. Es sind z.B. spezielle Schaltungen zur Temperaturkompension der Stellglieder erforderlich.

Fig. 1 zeigt eine andere Schaltung für einen Expander. Das Nutzsignal wird einer Eingangsklemme i zugeführt und das expandierte Ausgangssignal kann an der Ausgangsklemme 2 abgenommen werden. Zunächst wird das Nutzsignal in einem Schaltungsteil 3 bezüglich seines Pegels logarithmiert. Am Ausgang des Logarithmierers 3 findet eine Aufteilung des Vechselspannungssignales in den Hauptweg und den Zweigweg statt. Im Hauptweg schließen sich ein steuerbares Übertragungsglied 4 und im Zweigweg ein steuerbares Übertragungsglied 5 an. Von dem Ausgangssignal des steuerbaren Übertragungsgliedes 5 wird mittels eines Steuerspannungserzeugers 6 eine Steuerspannung $U_{ST}$ abgeleitet. Am Ausgang des Steuerspannungserzeugers 6 wird das Steuersignal aufgespalten und einerseits über ein Glied 7 mit konstantem Übertragungsmaß $k_1$ dem steuerbaren Übertragungsglied 4 im Hauptweg und andererseits über ein Glied 8 mit konstantem Übertragungsmaß $k_2$ dem steuerbaren Übertragungsglied 5 im Zweigweg zugeführt. Das Steuersignal wird den Übertragungsgliedern 4 und 5 also mit um einen konstanten Faktor $k_1/k_2$ unterschiedlichen Pegeln zugeführt.

Die Übertragungsglieder 4 und 5 sind folgendermaßen ausgeführt:

1. Bei unverändertem Steuersignal weist das Ürtragungsglied 4 bzw. 5 für das übertragene Vechselspannungssignal eine antilogarithmische Kennlinie auf.

2. Das Übertragungsmaß verändert sich in Abhängigkeit von einem zugeführten Steuer-Gleichspannungssignal entsprechend einer e-Funktion.

Im Betrieb der Schaltung überlagern sich diese beiden Eigenschaften der Schaltung. Die Fbertragungsglieder 4 und 5 lassen sich, wie weiter unten gezeigt werden wird, auf sehr einfache Veise ausführen.

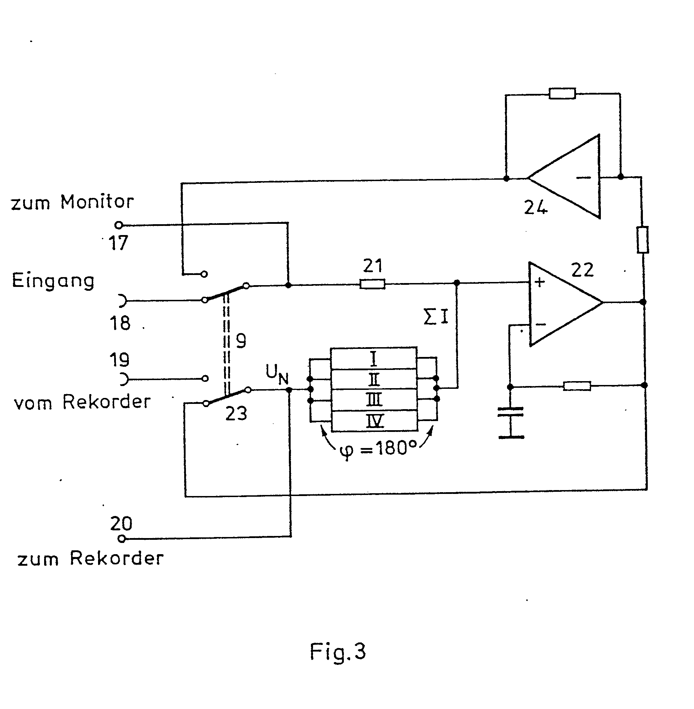

Fig. 3 zeigt eine Schaltungsanordnung für einen Kompander, die zwischen einem Kompressionsbetrieb und einem Expansionsbetrieb mittels eines Umschalters 9 umschaltbar ist. Es handelt sich um eine Kompanderschaltung, in der die Dynamik des zu verarbeitenden Signales in vier gestaffelten Frequenzbändern getrennt beeinflußt wird. Die Schaltungsteile, in denen die Dynamik des Nutzsignales bearbeitet wird, sind entsprechend den Frequenzbereichen mit I bis IV bezeichnet. Dieser Block enthält also viermal die Schaltung gemäß Fig. i und zusätzlich Frequenzweichen, auf die hier nicht näher eingegangen wird. Die Schaltung arbeitet in der gezeigten Stellung des Schalters 9 als Kompressor. Das Nutzsignal am Eingang 18 gelangt über einen Viderstand 21, und den Operationsverstärker 22 über den Schaltkontakt 23 des Schalters 9 zur Ausgangsklemme 20 beispielsweise zu einem Magnetband-Rekorder. Die Expansionsschaltungen I bis IV liegen dabei im Gegenkopplungsweg des Operationsverstärkers 22, wodurch sich eine zu der Expander-Kennlinie inwerse Kompressions-Kennlinie ergibt. Eine gegenkoppelnde Virkung der Schaltungsteile 1 bis IV wird dadurch erreicht, daß die Ausgangssignale dieser Schaltungsteile zu den Eingangssignalen eine Phasendrehung um 180° aufweisen, was einer Invertierung entspricht.

Beim Expansionsbetrieb der Schaltung in Fig. 3 steht der Schalter 9 in der nicht gezeichneten Schalterstellung. Jetzt liegt ein beispielsweise von einem Magnetband-Rekorder kommendes Nutzsignal an einer Eingangsklemme 19 und gelangt über den Schaltkontakt 23 und die Schaltungsteile I bis IV zum nichtinvertierenden Eingang des Operationsverstärkers 22. Der Operationsverstärker muß jetzt als Addierer für von den Schaltungsteilen I bis IV kommende Vechselströme arbeiten, wozu er mittels eines weiteren Operationsverstärkers 24 stark gegengekoppelt ist. Der Operationsverstärker 24 ist als Invertierer geschaltet und liegt zwischen dem Ausgang des Operationsverstärkers 22 und dem niht invertierenden Eingang, so daß sich insgesamt eine Gegenkopplung ergibt.

Der dem Schalter 9 zugewandte Anschluß des Viderstandes 21 ist mit einer Ausgangsklemme 17 verbunden, an die ein monitor angeschlossen werden kann.

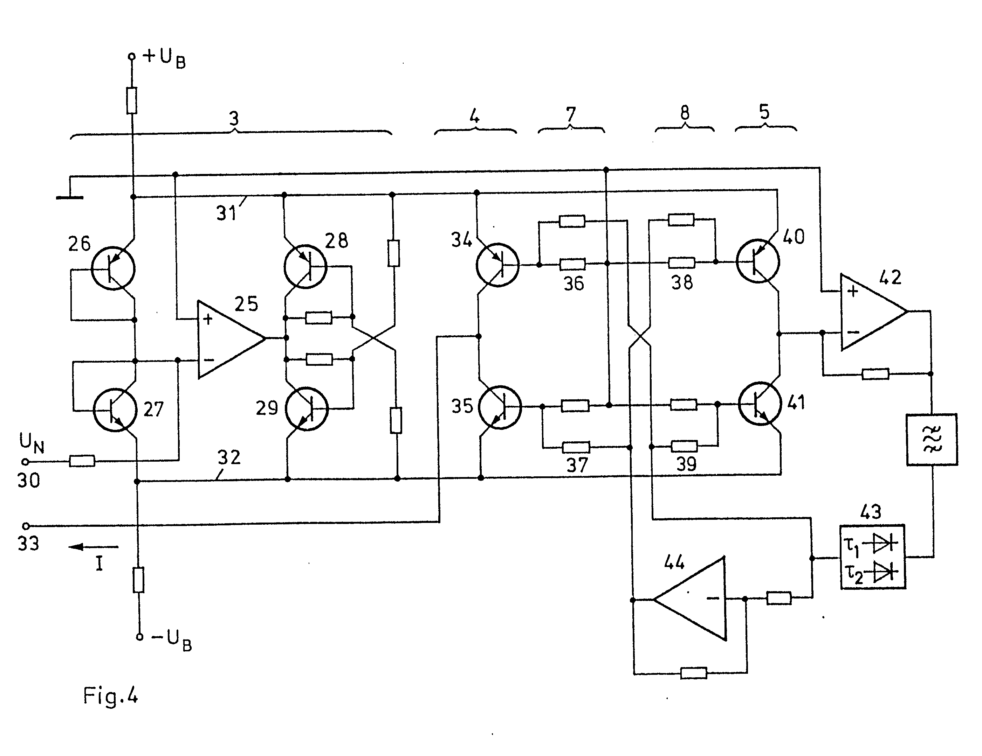

Fig. 4 zeigt ein Ausführungsbeispiel für eine Schaltung gemäß Fig. 1. Der Logarithmierer aus Fig. 1 ist in Fig. 4 mit einem Operationsverstärker 25 und Transistoren 26 und 27 im Gegenkopplungszwiig des Operationsverstärkers 25 aufgebaut. Veitere Transistoren 28 und 29 bewirken eine Pegelverschiebung des Ausgangssignales des Operationsverstärkers 25 und dienen zur Kompensation von $U_{BE}$-Spannungen der übrigen in der Schaltung enthaltenen Transistoren.

An einer Eingangsklemme 30 wird das Eingangs-Nutzsignal U dem invertierenden Eingang des Operationsverstärkers 25 zugeführt. Die Transistoren 26 und 27 im Gegenkopplungsweg des Operationsverstärkers 25 bewirken, daß das Nutzsignal mit einer logarithmischen Ubertragungs-Kennlinie übertragen wird, so daß an den Leitungen 31 und 32 das Nutzsignal mit logarithmisch verändertem Pegel erscheint. Die Signale auf diesen Leitungen sind phasengleich.

Das Signal auf den Leitungen 31 und 32 gelangt sowohl zu dem Stellglied 4 mit Transistoren 34 und 35 als auch zu dem Stellglied 5 mit den Transistoren 40 und 41. Jeweils die oberen Transistoren 34 und 40, welche PNP-Transistoren sind, dienen zur Beeinflussung der positiven Halbwellen des Signales und die unteren Transistoren 35 und 41, welche NPN-Transistoren sind, zur Bearbeitung der negativen Halbwellen, so daß die jeweils übereinander liegenden Transistoren zusammen ein komplettes Stellglied bilden.

Das Stellglied 40,41 gehört zum Zweigweg. Die Kollektorströme der Transistoren 40 und 41 werden in einem Operationsverstärker 42 zusammengeführt. Das Ausgangssignal des Operationsverstärkers 42 wird einem Schwellwert-Gleichrichter 43 mit Entlade-Zeitkonstante $\tau_1$ und Aufladezeitkonstante $\tau_2$ zugeführt. Am Ausgang des Gleichrichters 43 steht das Steuersignal für die Stellglieder zur Verfügung. Das Seuersignal wird den Transistoren der Stellglieder 4 und 5 jeweils an der Basis über je einen einen konstanten Faktor vorgebenden Spannungsteiler 36 bis 39 zugeführt. Die Kollektorströme der Transistoren 34,35 und 40,41 verhalten sich in Abhängigkeit von der angelegten Basisspannung nach einer e-Funktion.

Die Kollektorströme der beiden zu einem Stellglied gehörenden Transistoren werden summiert und stellen das Ausgangssignal des steuerbaren Übertragungsgliedes dar.

Die Stellglieder 4 und 5 sind entsprechend Fig. 1 zueinander invertiert angesteuert. Zur Steuerung eines Stellgliedes wird jeweils das Steuersignal einmal nichtinvertiert und zum anderen mittels eines Inverters 44 invertiert zugeführt. Die unterschiedlichen Transistoren erfordern diese unterschiedlichen Steuersignale.

Die Glieder 7 und 8 in Fig. 1 mit konstantem Übertragungsfaktor sind durch die den Basen der Transistoren 34,35 bzw. 40, 41 vorgeschalteten Spannungsteiler 36,37 (Glied 7) bzw. 38, 39 (Glied 8) ausgeführt.

Das Nutzsignal auf den Leitungen 31 und 32 liegt jeweils am Emitter der Transistoren der Stellglieder 4 und 5. Bei dieser beschaltung weisen die Stellglieder für das Nutzsignal ein antilogarithmisches Übertragungsverhalten auf. Wenn beispielsweise die Spannung an den Basen der Transistoren der Stellglieder als konstant angenommen wird und nur die Änderung des Nutzsignales betrachtet wird, so erscheint das Nutzsignal am Ausgang der Stellglieder (Summe der Kollektorströme der Transistoren der Stellglieder) wieder mit den ursprünglichen, nicht logarithmischen Pegelverhältnissen.

Die jeweils mit zwei Transistoren aufgebauten Stellglieder vereinigen zwei Eigenschaften in sich:

1. Sie stellen ein Übertragungsglied mit antilogarithmischem Übertragungsmaß dar.

2. Sie weisen eine einer e-Funktion entsprechende Steuercharakteristik auf.

Wie das Ausführungsbeispiel zeigt, kann man die Stellglieder mit sehr einfachen Mitteln aufbauen. Lineare Stellglieder, die z.B. durch die DE-OS 28 47 436 bekannt sind, sind demgegenüber aufwendiger.

An der Ausgangsklemme 33 der Schaltung gemäß Fig. 4 kann ein Strom abgenommen werden, der durch eine Schaltung gemäß Fig. 3 in eine Signalspannung umgewandelt werden kann, wobei wiederum mehrere Ströme gleichartiger Schaltungen für die verschiedenen Frequenzbänder gemäß Fig. 3 zusammengeführt werden können.

Der Kompressionsgrad der Schaltung in Fig. 4 kann auf einfache Weise durch bestimmte Bemessung der Spannungsteiler 36 bis 39 beliebig vorgegeben werden. Vie bereits bei Fig. 1 ausgeführt, gehen die dabei auftretenden Faktoren direkt linear in den Expansionsgrad bzw. Kompressionsgrad der Schaltung ein.

Die Erfindung ist nicht auf das beschriebene Ausführungsbeispiel beschränkt. Es kann für die gesteuerten Übertragungsglieder beispielsweise auch ein Glied mit antilogarithmischer Übertragungskennlinie jedoch einer von der e-Funktion abweichenden Steuercharakteristik verwendet werden. Die erforderliche Steuercharakteristik (e-Funktion) kann dann mittels entsprechend ausgelegten Kennliniengebern für das Steuersignal herbeigeführt werden. In einem solchen Fall ist der Kennliniengeber als mit zu dem Stellglied gehörig zu betrachten.

**Patentansprüche**

1. Schaltung zur automatischen Dynamik-Kompression oder -Expansion in einem Nutzsignalweg (1, 2, 3, 4), bei der vom Nutzsignalweg ein Zweigweg (4, 6, 7) abgzweigt ist, in dem aus dem Nutzsignal in einem Steuerspannungserzeuger (6) eine Steuerspannung ($U_{ST}$) gewonnen wird, und bei der in gesteuerten Übertragungsgliedern (4,5) sowohl im Nutzsignalweg als auch im Zweigweg mit der Steuerspannung ($U_{ST}$) eine Änderung des Übertragungsmaßes des Nutzsignalweges bzw. Zweigweges vorgesehen ist, wobei die Änderung des Über-tragungsmaßes im Zweigweg im Sinne einer Gegenregelung erfolgt, <u>dadurch gekennzeichnet</u>, daß das Nutzsignal in einem Logarithmierer (3) in ein Signal mit logarithmischem Signal-Pegel umgewandelt wird und die Ableitung des Nutzsignales für den Zweigweg (5, 6, 7, 8) an einer Stelle hinter dem Lagarithmierer (3) erfolgt, daß die gesteuerten Übertragungsglieder (4, 5) im Nutzsignalweg und Zweigweg als Stellglieder mit einer der e-Funktion entsprechenden Steuer-Charakteristik und einer für das Nutzsignal antilogarithmischen Übertragungs-Kennlinie ausgeführt sind, und daß den steuerbaren Übertragungsgliedern (4, 5) im Nutz- und Zweigsignalweg die Steuersignale mit um einen konstanten Faktor $k_1/k_2$ unterschiedlichen Pegeln zugeführt sind, wobei $k_1$ und $k_2$ unterschiedliche konstante Übertragungsmaße für die Steuerspannung ($U_{ST}$) darstellen.

Schaltung nach Anspruch 1, <u>dadurch bekennzeichnet</u>, daß für die gesteuerten Übertragungsglieder (4,5) die Eigenschaft eines bipolaren Transistors, bei dem der Kollektorstrom sich nach einer e-Funktion in Abhängigkeit von der Basis-Emitter-Spannung ändert, ausgenutzt ist.

Schaltung nach Anspruch 2, <u>dadurch gekennzeichnet</u>, daß jedes gesteuerte Übertragungsglied mit einem NPN-Transistor (35) und einem PNP-Transistor (34) aufgebaut ist. daß die Steuerspannung den beiden Transistoren zueinander invertiert zugeführt ist, daß den Emittern das Nutzsignal zugeführt ist und daß die Ströme der Kollektoren der beiden Transistoren addiert werden und das Ausgangssignal (7) des steuerbaren Übertragungsgliedes darstellen.

4. Schaltung nach Anspruch 3, <u>dadurch gekennzeichnet</u>, daß die Kollektoren der Transistoren (34,35) miteinander verbunden sind.

5. Schaltung nach Anspruch 3, <u>dadurch gekennzeichnet</u>, daß die Steuerspannung den Basen der Transistoren (34, 35) über je einen Spannungsteiler (36,37) zugeführt ist.

6. Schaltung nach Anspruch 5, <u>dadurch gekennzeichnet</u>, daß die gesteuerten Übertragungsglieder (34,35;40,41) im Nutzsignalweg und Zweigweg zueinander gleich aufgebaut sind.

7. Schaltung nach Anspruch 6, <u>dadurch gekennzeichnet</u>, daß das Teilungsverhältnis der Spannungsteiler (36,37) jeweils eines gesteuerten Übertragungsgliedes (4) zueinander gleich ist.

8. Schaltung nach Anspruch 7,<u>dadurch gekennzeichnet</u>, daß die Teilungsverhältnisse der Spannungsteiler (36,37) des gesteuerten Übertragungsgliedes (34, 35) im Nutzsignalweg sich um einen konstanten Faktor $k_1/k_2$ von dem Teilungsverhältnis der Spannungsteiler (38.39) des Übertragungsgliedes (40,41) im zweigweg unterscheiden.

9. Schaltungsanordnung nach Anspruch 3, <u>dadurch gekennzeichnet</u>, daß den Emittern der Transistoren (34,35;40,41) das Nutzsignal zur Kompensation der $U_{BE}$-Spannungen der Transistoren (34,35;40,41) der gesteuerten Übertragungsglieder um einen konstanten Spannungswert gegeneinander versetzt zugeführt sind.

**Claims**

1. Circuit for tha automatic dynamic compression or expension in an intelligencs signal path (1, 2, 3, 4), in which branched off from the intelligence signal path is a branch path (4, 6, 7), in which a control voltage ($U_{ST}$) is obtained in a control voltage generator (6) from the intelligence signal, and in which a change in transmission constant of the intelligence signal path or the branch path is provided by the control voltage ($U_{ST}$) in controlled transmission members (4, 5) in the intelligence signal path as well as also in the branch path, wherein the change in transmission constant takes place in the sense of a balancing regulation in tha branch path, characterised thereby, that the intelligence signal is converted in a logarithmator (3) into a signal of logarithmic signal level and the derivation of the intelligence signal for the branch path (5, 6, 7, 8) takes place at a point behind the logarithmstor (3), that the controlled transmission members (4, 5) in the intelligence signal path and branch path are executed as setting members with a control characteristic corresponding to the exponential function and an antilogarithmic transmission characteristic for the intelligence signal and that the control signals are conducted at levels differing by a constant factor $K_1/K_2$ to the controllable transmission members in the intelligence signal path and branch path, wherein $K_1$ and $K_2$ represent differenttransmission constants for the control voltage ($U_{ST}$).

2. Circuit according to claim 1, characterised thareby, that the property of a bipolar transistor, in which the collector current changes according to an exponential function in dependence on the base-emitter voltage, ia exploited for controlled transmission members (4, 5).

3. Circuit according to claim 2, characterised thereby, that each controlled transmission member is built up with an NpN-transistor (35) and a pNp-transistor (34), that the control voltage is fed relatively inverted to both the transistors, that the intelligence signel is fed to the emitters and that the currents of the collectors of both the transistors are added and represent the output signal (7) of the controllable transmission member.

4. Circuit according to claim 3, characterised thereby, that the collectors of the transistors (34, 35) are each connected with the other.

5. Circuit according to claim 3, characterised thereby, that the control voltage is fed by way of a respective voltage divider (36, 37) to each of tha bases of the transistors (34, 35).

6. Circuit according to claim 5, characterised thereby, thst the controlled transmission members (34, 35; 40, 41) in the intelligence eignal path and branch path are built up each like the other.

7. Circuit according to claim 6, characterised thereby, that the dividing ratio of the voltage dividers (36, 37) of each controlled transmission member (4) is each equal to the other.

8. Circuit according to claim 7, characterised thereby, that the dividing rstios of the voltage dividers (36, 37) of the controlled transmission member (34, 35) in the intelligence signal path differ by a constant factor $K_1/K_2$ from the dividing ratio of the voltage divider (38, 39) of the transmission member (40, 41) in the branch path.

9. Circuit arrangement according to claim 3, characterised thereby, that the intelligence signal is fed to the emitters of the transistors (34, 35; 40, 41) displaced one relative to the other by a constant voltage value for compensation of the base-emitter voltages of the transistors (34, 35; 40, 41) of the controlled transmission members.

**Revendications**

1. Montage de compression ou d'extension automatique dans un circuit de signal utile (1, 2, 3, 4) sur lequel est derive un circuit (4, 6, 7) dans lequel un genérateur (6) delivre une tension de commande ($U_{ST}$) à partir du signal utile, et dans les organes de transfert commandes (4, 5) du circuit du signal utile et du circuit derivé, la tension de commande ($U_{ST}$) fait varier l'exposant de transfert du circuit du signal utile et du circuit derive, la variation de l'exposant de transfert dans le circuit dérivé se faisant dans le sens d'une régulation inverse, ledit montage étant caractérisé en ce que le signal utile est converti dans un extracteur de logarithme (3) en un signal à niveau logarithmique et la dérivation du signal utile pour le circuit dérivé (5, 6, 7, 8) s'effectue en aval dudit extracteur (3); les organes de transfert commandés (4, 5) du circuit de signal utile et du circuit dérivé sont réalisés sous forme d'organes de réglage ayant une caractéristique de commande correspondant à une fonction e et une caractéristique de transfert antilogarithmique pour le signal utile; et les signaux de commande sont appliqués, avec des niveaux différant d'un facteur constant $k_1/k_2$, aux organes de transfert commandes (4, 5) du circuit de signal utile et du circuit dérivé, $k_1$ et $k_2$ étant des exposants de transfert constant et différents de la tension de commande ($U_{ST}$).

2. Montage selon revendication 1, caractérisé en ce que la propriété d'un transistor bipolaire, dont le courant collecteur varie exponentiellement en fonction de la tension base-émetteur, est utilisée pour les organes de transfert commandes (4, 5).

3. Montage selon revendication 2, caractérisé en ce que chaque organe de transfert commandé est constitué par un transistor NPN (35) et un transistor PNP (34); la tension de commande est appliquée avec inversion aux deux transistors; le signal utile est appliqué aux émetteurs; et les courants des collecteurs des deux transistors sont additionnés et constituent le signal de sortie (7) de l'organe de transfert commandé.

4. Montage selon revendication 3, caractérisé en ce que les collecteurs des transistors (34, 35) sont reliés entre eux.

5. Montage selon revendication 3, caractérisé en ce que la tension de commande est appliquée à la base de chaque transistor (34, 35) par un diviseur de tension (36, 37).

6. Montage selon revendication 5, caractérisé en ce que les organes de transfert commandés (34, 35; 40, 41) sont identiques dans le circuit du signal utile et le circuit dérive.

7. Montage selon revendication 6, caractérisé en ce que le rapport des diviseurs de tension (36, 37) d'un organe de transfert commandé (4) est le même.

8. Montage selon revendication 7, caractérisé en ce que les rapports des diviseurs de tension (36, 37) de l'organe de transfert commandé (34, 35) dans le circuit du signal utile diffèrent d'un facteur constant $k_1/k_2$ du rapport dés diviséurs de tension (38, 39) de l'organe dé transfért (40, 41) du circuit dérivé.

9. Montage selon revendication 3, caractérisé en ce que le signal utile est applique aux émetteurs des transistors (34, 35; 40, 41) avec une tension constante différente pour chacun, afin de compenser les tensions $U_{BE}$ des transistors (34, 35; 40, 41) des organes de transfert commandés.

Fig.1

Fig.2                    (bekannte Expansionsschaltung)

1

Fig.3

Fig.4

0 053 303